(19) Europäisches Patentamt

European Patent Office

Office européen des brevets

(11) **EP 1 006 373 A2**

(12) **EUROPÄISCHE PATENTANMELDUNG**

(43) Veröffentlichungstag:
 **07.06.2000 Patentblatt 2000/23**

(51) Int. Cl.[7]: **G02B 1/02**, G03F 7/20,
 G02B 13/14

(21) Anmeldenummer: **99121434.7**

(22) Anmeldetag: **28.10.1999**

(84) Benannte Vertragsstaaten:
 **AT BE CH CY DE DK ES FI FR GB GR IE IT LI LU MC NL PT SE**
 Benannte Erstreckungsstaaten:
 **AL LT LV MK RO SI**

(30) Priorität: **29.06.1999 DE 19929701**
 **30.11.1998 DE 19855158**
 **27.02.1999 DE 19908544**

(71) Anmelder:
 • **Carl Zeiss**
  **89518 Heidenheim (Brenz) (DE)**
  Benannte Vertragsstaaten:
  **DE FR NL**
 • **Carl-Zeiss-Stiftung trading as Carl Zeiss**
  **89518 Heidenheim (Brenz) (DE)**
  Benannte Vertragsstaaten:
  **GB**

(72) Erfinder: **Schuster, Karl-Heinz**
 **89551 Königsbronn (DE)**

(54) **Objektiv mit Kristall-Linsen und Projektionsbelichtungsanlage der Mikrolithographie**

(57) Ein Objektiv mit Linsen aus zwei verschiedenen Kristallen, insbesondere $CaF_2$ und $BaF_2$, eignet sich besonders als refraktives Projektionsobjektiv der Mikrolithographie bei 157 nm. Derartige Projektionsobjektive für 193/248 nm mit Quarzglas und Achromatisierung mit $CaF_2$ werden mit $BaF_2$ Compaction-resistent.

Mit anderen Fluoriden und teilweise katadioptrischen Objektiven werden Mikrolithographie-Projektionsbelichtungsanlagen im Wellenlängenbereich 100 - 200 nm möglich.

*FIG.1*

EP 1 006 373 A2

**Beschreibung**

Die Erfindung betrifft ein Objektiv mit Kristall-Linsen. Derartige Objektive sind seit über hundert Jahren als Apochromat-Mikroskopobjektive von Carl Zeiss mit Flußspat ($CaF_2$)-Linsen bekannt.

In jüngerer Zeit werden refraktive Projektionsobjektive für die Mikrolithographie im DUV bei 248 oder 193 nm Wellenlänge realisiert, die Linsen aus Quarzglas und $CaF_2$ enthalten.

Aus DD 222 426 B5 ist ein optisches System mit optischen Gläsern und $BaF_2$-Einkristall als optische Medien bekannt, das für Wellenlängen von 150 bis $10^4$ nm eingesetzt werden kann. Das Ausführungsbeispiel ist ein Planapochromat für 480 bis 800 nm mit mehreren verschiedenen Gläsern und $BaF_2$.

Die Materialauswahl für UV-Mikrolithographieobjektive - mit Schwerpunkt auf der Wellenlänge 248 nm - ist in G. Roblin, J. Optics (Paris), 15 (1984) pp. 281-285 beschrieben.
Im Ergebnis werden nur Kombinationen von Quarzglas mit $CaF_2$ oder LiF als brauchbar eingestuft.

In U. Behringer, F + M (München) 107 (1999), 57-60 sind für die 157 nm Mikrolithographie Fluoride wie $CaF_2$, $M_gF_2$ und LiF als geeignet beschrieben, mit Vorbehalten wegen der Doppelbrechung von MgF2 und wegen der Handhabung von LiF.

In K.F. Walsh et al., SPIE Vol. 774 (1987), 155-159 werden u.a. die Excimer-Laser für 248, 193 und 157 nm Wellenlänge vorgestellt und für 248 nm Quarzglas, $CaF_2$, $BaF_2$ und $MgF_2$ als einzig brauchbare Linsenmaterialien benannt. Für Wellenlängen unter 248 nm wird Quarzglas als einzig brauchbares Material erwartet.

In US 5,031,977 wird ein katadioptrisches 1:1 Projektionsobjektiv für die Mikrolithographie bei 248 nm beschrieben, das einen Konkavspiegel, eine Quarzglaslinse, eine LiF-Linse und zwei Umlenkprismen aus $CaF_2$ enthält. Argumente zur Materialauswahl sind ebensowenig angegeben wie Hinweise zu Abwandlungen der speziellen Konstruktion.

Nahe bei 157 nm liegt jedoch die Absorptionskante von Quarzglas. $CaF_2$ transmittiert bei 157 nm noch brauchbar, hat aber eine zu hohe Dispersion für ein reines $CaF_2$-Objektiv der Mikrolithographie, auch für einen spektral eingeengten $F_2$-Excimer-Laser. Bisher sind daher Objektive für Wellenlängen unter 193 nm nur als katadioptrische- vgl. DE 196 39 586 A des gleichen Erfinders und Anmelders und US Prov. Appln. Ser. No. 60/094,579 vom 29. Juli 1998 des gleichen Anmelders - oder katoptrische - vgl. US 5,686,728 - Systeme bekannt. Dabei gibt US 5,686,728 ein reines Spiegelobjektiv für die VUV-Mikrolithographie mit beispielsweise 126 nm, 146 nm oder 157 nm Excimer-Laser an.

Aufgabe der Erfindung ist die Angabe eines alternativen Objektivkonzepts mit einer Materialzusammenstellung, die neue Anwendungsmöglichkeiten, insbesondere in der Mikrolithographie bei niedrigen Wellenlängen eröffnet.

Gelöst wird diese Aufgabe durch ein Objektiv nach Anspruch 1, ein Projektionsobjektiv der Mikrolithographie nach Anspruch 4, oder 9, 11, 12 und eine Projektionsbelichtungsanlage nach Anspruch 16, 17 oder 18. Vorteilhafte Ausführungsformen sind Gegenstand der Unteransprüche 2, 3, 5-8, 10, 14-16,19-21 und 23.

Einen Teilaspekt gibt Anspruch 13 an.

Ein Verfahren zur Herstellung mikrostruktuierter Bauteile gemäß Anspruch 22 sieht vor, daß ein mit einer lichtempfindlichen Schicht versehenes Substrat mittels einer Maske und einer Projektionsbelichtungsanlage nach mindestens einem der Ansprüche 17 bis 21 - und damit mit einem Objektiv nach einem der vorangehenden Ansprüche - durch ultraviolettes Licht belichtet wird und gegebenenfalls nach Entwickeln der lichtempfindlichen Schicht entsprechend einem auf der Maske enthaltenen Muster strukturiert wird.

Die Erfindung geht aus von der Erkenntnis, daß sich durch die Verwendung zweier verschiedener Kristalle in einem Objektiv neuartige Objektiveigenschaften bereitstellen lassen. Insbesondere gehört dazu die Möglichkeit der Achromatisierung bei niedrigen Wellenlängen, bei denen jedes bekannte Glas, auch Quarzglas, stark absorbiert. Die in der Mikrolithographie gegen $BaF_2$ vorhandenen Vorbehalte beziehen sich auf 248 nm und Quarzglas als Partner.

Alkali- und Erdalkalihalogenide, speziell deren Fluoride, wie auch andere Fluoride sind als Optik-Werkstoff bekannt. Ihre zum Teil schwierigen Werkstoffeigenschaften haben bisher dazu geführt, daß ihre hervorragenden Transmissionseigenschaften im tiefen UV nur ansatzweise ausgenutzt wurden. Erfindungsgemäß wurde gezeigt, daß mit diesen und ähnlichen Materialien die optische Mikrolithographie bis zu ca. 100 nm Wellenlänge nach unten ausgedehnt werden kann.

Mit der Paarung zweier Fluoridkristalle, insbesondere von $CaF_2$ BaF2, $SrF_2$ LiF, NaF, oder KF, aber auch von Mischkristall-Fluoriden kann erstmals ein Materialpaar zur Achromatisierung von 157 nm-Optiken angegeben werden. Die Materialien sind bereits in der Optik-Fertigung bekannt, wie der angegebene Stand der Technik belegt. Bariumfluorid, Strontiumfluorid oder Natriumfluorid wird dabei entsprechend Anspruch 6 vorzugsweise für Negativlinsen verwendet, und zwar nur für einzelne, weil das genügen kann. Kalziumfluorid findet dann gemäß Anspruch 7 nicht nur für die Positivlinsen, sondern auch für die restlichen Negativlinsen Verwendung.

Besonders vorteilhaft ist es gemäß Anspruch 8, daß numerische Aperturen über 0,5, auch bei 157 nm, erreicht werden. Das folgende Beispiel mit der numerischen Apertur von 0,8 belegt dies deutlich. Damit wird der Auflösungsvorsprung der EUV-Mikrolithographie durch ca. 1/10 der Wellenlänge teilweise kompensiert, da ca. die dreifache NA erreicht wird. Gegenüber 193 nm kann mit 109 nm aber die Auflösung fast halbiert werden., da das Niveau der NA gehalten wird.. Für die Bearbeitungsgenauigkeit hat die zehnfache Wellenlänge gegenüber EUVL drastische Vorteile.

Das Stitching-Verfahren (zeilenweise Belichten des Chips) gemäß Anspruch 20, welches neuerdings in der Mikrolithographie bei sehr niedrigen Wellenlängen ins Gespräch kommt, erlaubt verkleinerte Bildfelder als Rechtecke mit mäßigem Aspektverhältnis und sorgt so für eine drastische Verkleinerung der Objektive. Letzteres entspannt die Herstellungsprobleme für die Linsenkristalle drastisch.

Eine ganz andere Ausführungsart der Erfindung gemäß den Ansprüchen 9 und 10 wurde überraschend gefunden:

Bei der DUV-Mikrolithographie mit 248 nm oder 193 nm tritt im Dauerbetrieb ein als "Compaction" bezeichneter Alterungsprozeß bei Quarzglas auf, durch den das Material verdichtet wird und in Folge Brechungsindex und Form der Linse verändert werden. Dies verschlechtert natürlich die Abbildungsleistung des Objektivs. Neben der Kompensation durch stellbare Glieder wurde erkannt, daß die am höchsten belasteten und betroffenen bildseitigen Linsen statt aus Quarzglas aus Kristall, nämlich vorzugsweise $CaF_2$, $SrF_2$ oder $BaF_2$ gefertigt werden können, die wesentlich stabiler gegen UV-Strahlung sind.

In der Patentanmeldung DE 19855157.6 des Anmelders vom gleichen Anmeldetag sind mehrere Ausführungsbeispiele mit derartigem Einsatz von Kalziumfluorid-Linsen enthalten, welche Teil der Offenbarung auch dieser Anmeldung sein sollen.

Dabei hat $BaF_2$ wie $SrF_2$ an dieser Stelle nach Anspruch 9 den - im Umfeld der Achromatisierung als Nachteil geltenden - Vorteil, sich in seinen optischen Eigenschaften wesentlich weniger von Quarzglas zu unterscheiden als $CaF_2$ (vgl. Roblin am angegebenen Ort). Die Designänderungen eines Projektionsobjektivs bei Austausch von Quarzlinsen gegen $BaF_2$- oder SrF2-Linsen in Bildnähe sind daher minimal. Das Projektionsobjektiv wird so durch den Einsatz von zwei kristallinen Materialien - $CaF_2$ für die Achromatisierung, $BaF_2$ oder $SrF_2$ gegen die Compaction - optimiert.

Für ein 157 nm-Objektiv, rein refraktiv und aus einem Material, also $CaF_2$, wären Laserbandbreiten bis hinter zu 0,1 pm notwendig, abhängig von Apertur und Bildfeldgröße.

Es ist nicht zu erwarten, daß diese Werte einfach erreicht werden können beim Wechsel von 193 auf 157 nm. Alles wird nochmals anspruchsvoller, Materialdurchlässigkeit, Schichtverfügbarkeit, Gitter für die Laserkomponenten.

Erfindungsgemäß wurde mit $BaF_2$ ein Material gefunden, welches bei 157 nm transparent und isotrop ist, welches eine merklich höhere Dispersion bei 157 nm als $CaF_2$ besitzt und sich mit diesem zum Achromaten ergänzen läßt. $BaF_2$ absorbiert erst bei etwa 130 nm vollständig. Die Nähe der Absorptionskante zu 157 nm ist verantwortlich für den raschen Verlauf der Brechzahländerung (starke Dispersion) bei 157 nm. Entsprechendes gilt für andere Fluoride wie $SrF_2$.

Bei 193 nm ist die Achromatisierung durch die Kombination von $CaF_2$ und Quarzglas etabliert. $BaF_2$ hat eine nur unwesentlich höhere Dispersion als $CaF_2$ und liegt in der Dispersion sozusagen nutzlos zwischen der Dispersion von $CaF_2$ und Quarzglas.

Für 157 nm ändert sich die Situation, da Quarzglas erhöhte Absorption zeigt. Nach bisheriger allgemeiner Meinung gab es nun für $CaF_2$ keinen geeigneten Partner zur Achromatisierung.

Dies ist nicht der Fall: Der Dispersionsabstand zwischen $CaF_2$ und $BaF_2$ bei 157 nm fällt zwar kleiner aus als zwischen $CaF_2$ und Quarzglas bei 193 nm, aber es läßt sich unter moderatem Einsatz von $BaF_2$ immer noch sehr gut teilachromatisieren, auf ähnlichem Niveau wie bei 193 nm, z.B. 50% Farblängsfehlerreduktion.

Bei 193 nm wird allgemein nur eine Teilachromatisierung durchgeführt, um das eingesetzte $CaF_2$ Volumen aus Gründen der Kosten, der Verfügbarkeit und der Materialeigenschaften klein zu halten. Bei 157 nm wird man den Partner $BaF_2$ im Volumen kleinhalten wollen, da er ein höheres spezifisches Gewicht hat und sich die $BaF_2$-Linsen dadurch unter der Schwerkraft stärker durchbiegen.

Bei 193 nm möchte man möglichst alles aus Quarzglas machen, bei 157 nm möglichst alles aus $CaF_2$. Da die Zahl der positiven Linsen im refraktiven Lithographie-Objektiv deutlich größer ist als die der negativen, wäre es vorteilhaft bei 193 nm, wenn Quarzglas eine kleine Dispersion hätte. Es ist aber umgekehrt, $CaF_2$ hat die kleinere Dispersion und kann nicht bzw. soll nicht in allen positiven Linsen eingesetzt werden. Es werden also positive Linsen aus Quarzglas gemacht, was den Grad der Achromatisierung drückt.

Bei 157 nm ist es ebenfalls wünschenswert, daß das bevorzugte Material, hier $CaF_2$, eine kleinere Dispersion als der Partner hat.

Im Gegensatz zu 193 nm ist dies bei 157 nm mit $BaF_2$ der Fall. Fast alle Linsen, sicher alle positiven Linsen, können aus dem Kron, nämlich $CaF_2$, sein. Einige wenige Negativlinsen werden aus $BaF_2$ gemacht, alternativ aus $SrF_2$, denn dafür gilt qualitativ das gleiche wie für $BaF_2$.

Natürlich gelten die obigen Aussagen auch für Linsen in einem katadioptrischen Objektiv, insbesondere auch für dabei vewendete refraktive Teilobjektive. Das erfindungsgemäße Objektiv kann also auch katadioptrisch sein. Wichtig ist, daß Linsen, und nicht nur optische Hilfselemente wie Umlenkprismen oder Planplatten aus Kristall bestehen.

Möchte man Lithographie mit einer kürzeren Wellenlänge als 157 nm und gleichzeitig mit sehr hoher numerischer Apertur betreiben, begegnet man einer Fülle schon bekannter Probleme in verschärfter Form. Zunächst muß man sich im Klaren sein, daß nur bei Excimer-Laserwellenlängen eine geeignete Bandbreite und Ausgangsleistung der Lichtquelle zu erwarten ist. Die Spektren der Edelgase emittieren zwar auch etwa ab 60 nm, nur sind diese sehr breitbandig und damit nur reinen Spiegelsystemen zugänglich. Reine Spiegelsysteme mit wirklich ausgedehntem Feld zwischen 10 und 26 mm haben bis jetzt keine Apertur größer NA = 0,6.

Excimer-Laser können auf folgenden Wellenlängen unterhalb von 157 nm betrieben werden:

| | |
|---|---|
| NeF | 109 nm |
| Ar2 | 126 nm |
| ArKr | 134 nm |
| Kr2 | 147 nm |

Bei der Materialfrage ist ein bekannter Kandidat mit sehr guter Transmission für 134 und 147 nm $CaF_2$. Für 134 und 147 nm sind katadioptrische Objektive mit ausschließlich CaF2 als Linsenmaterial denkbar und stellen somit nichts Neues dar. Möchte man refraktive Objektive mit mehr Apertur bekommen, wie 0,80/0,85/0,90, so erschließt sich die Wellenlänge 147 nm noch durch das oben für 157 nm angegebene Materialsystem: Positive Linsen vorwiegend aus $CaF_2$, einige negative Linsen aus $BaF_2$. Da die Absorptionskante von $BaF_2$ etwa bei 134,5 nm liegt, ist man noch etwa 13 nm bei 147 nm entfernt. Dies bedeutet eine erhöhte Absorption, ermöglicht aber eine entspanntere Farblängsfehlerkorrektur, da $BaF_2$ bei 147 nm nun eine stärkere Dispersion hat als bei 157 nm, und zwar mit höherer Zunahme als $CaF_2$, da die Absorptionskante von $CaF_2$ bei 125 nm liegt.

Mit anderen Worten: bei gleich guter Bandbreite der Laser von 157 nm und 147 nm liefert bei einem rein refraktiven Objektiv ein Materialpaar $CaF_2$ und $BaF_2$ bei 147 nm das bessere Ergebnis hinsichtlich Farbkorrektur. Die Absorptionsverluste sind allerdings höher.

Auch bei 134 nm wurde bisher kein Materialpaar zur Achromatisierung rein refraktiver Systeme angegeben. Erfindungsgemäß wurde dies in dem Materialpaar $CaF_2$ - $SrF_2$ gefunden. Der Abstand zur Absorptionskante von $SrF_2$ bei 130 nm muß aber als sehr gering eingestuft werden. Die erhöhte Absorption läßt den Kristall nur für sehr dünne und kleine Negativlinsen sinnvoll erscheinen. Deshalb wird ein derartiges System nur für kleinere Bildfelder, etwa ein Halbfeldsystem (Stitching) realistisch sein.

Bei 126 nm scheidet auch $CaF_2$ vollständig aus, da der Abstand zur Absorptionskante nur noch 1 nm beträgt.

Es bleiben als bekannte Werkstoffe $MgF_2$ und LiF. $MgF_2$ ist auch bei 126 nm stark doppelbrechend und damit ungeeignet. LiF ist bei 126 nm zwar durchlässig, gilt aber für kleinere Durchmesser als ungeeignet, da die Strahlungsbelastung steigt und das Material sich dadurch unzulässig verändert (Transmission und Brechzahl). Selbst ein katadioptrisches System kommt im Bereich der höchsten Apertur (vor der Bildebene) nicht ohne Material im Durchtritt aus. Somit würde man für 126 nm kein hochgeöffnetes Lithographieobjektiv mit großem Feld mehr bauen können.

Erfindungsgemäß kann nun ein weiteres Material speziell für die hochbelasteten Meinen Durchmesser angegeben werden. Die Konfiguration bei 126 nm besteht aus einem katadioptrischen Lithographieobjektiv, welches hauptsächlich aus LiF besteht. In den mit hoher Strahlungsintensität belasteten Linsen besteht es jedoch aus der isotropen amorphen Form von $BeF_2$. Die kristalline Form ist ähnlich dem kristallinen Quarz doppelbrechend. Die glasig erstarrte Form, ähnlich dem Quarzglas, ist bei entsprechender Herstellung isotrop. Da $BeF_2$ bei 126 nm deutlich laserresistenter ist als LiF, ist es das geeignete Material in wenigen Linsen entweder in einer Strahltaille oder mehreren Strahltaillen und/oder am bildseitigen Ende des Objektivs. Die geringe Zahl von $BeF_2$-Linsen ist letztlich anzustreben, da $BeF_2$ als starkes Atemgift und schwächeres Kontaktgift eingestuft werden muß. Für den Infrarotbereich gibt es schon lange Fertigungslinien, die den Umgang mit giftigen optischen Komponenten beherrschen. Trotzdem ist es vorteilhaft, die Zahl der $BeF_2$-Linsen auf das Allernotwendigste zu beschränken. Es handelt sich also um ein refraktives oder katadioptrisches Lithographieobjektiv aus mindestens einem kristallenem und einem glasigen Fluorid.

$BeF_2$ muß wasserfrei hergestellt und bearbeitet werden, da es zu $H_2O$-Aufnahme neigt und das $H_2O$ sofort die Wellenlänge 126 nm sperrt.

Besonders $H_2O$-arme $BeF_2$-Herstellung macht auch die HeF-Laserwellenlänge bei 109 nm zuganglich. Beide Komponenten in hochreiner Form, LiF und $BeF_2$, ermöglichen ein katadioptrisches Objektiv bei 109 nm.

Optische Materialien großer Dispersion werden herkömmlich als Flint(glas), solche geringer Dispersion als Kron(glas) bezeichnet.

Für die verschiedenen DUV bis VUV-Wellenlängen werden gemäß Obengesagtem die im folgenden kompakt wiedergegebenen Materialkombinationen vorgeschlagen:

4

| - 193 nm: | - CaF$_2$ Kron | KF Flint |
|---|---|---|
| | - CaF$_2$ Kron | KF + SiO$_2$-Glas Flint |
| | - LiF +, CaF$_2$ Kron | KF Flint |
| | - LiF +, CaF$_2$ Kron | KF + SiO$_2$-Glas Flint |
| - 157 + 147 nm: | CaF$_2$ und/oder LiF Kron | NaF, BaF$_2$, und/oder SrF$_2$ Flint |
| - 134 nm: | - CaF$_2$ Kron | SrF$_2$ Flint |
| | - CaF$_2$ Kron | NaF Flint |
| | - LiF Kron | SrF$_2$ Flint |
| | - LiF Kron | NaF Flint |
| | - LiF Kron | NaF + SrF$_2$ Flint |
| dabei SrF$_2$ für kleine Durchmesser, da strahlungsbeständiger als NaF | | |

Die oben genannten Systeme können mit Dünnschichtsystemen aus MgF$_2$ und LaF$_3$ entspiegelt werden. Für 193 nm eignen sich zudem auch SiO$_2$ und Al$_2$O$_3$ als Antireflexschichten.

Diese Möglichkeit der Entspiegelung ist eine wichtige Voraussetzung für die Realisierbarkeit von vielgiledrigen refraktiven Objektiven, da sonst pro Linsenfläche ca. 10 % Reflexionsverlust auftritt.

Da für 126 nm und 109 nm keine Antireflex-Schichten bekannt sind, ist dies ein weiterer Grund, warum hier katadioptrische Systeme mit wenigen (z. B. 3-5) Linsen vorzuziehen sind, entsprechend Anspruch 12.

Beim Achromatisieren mit LiF und NaF bietet sich eine Möglichkeit, Grenzflächen Kristall-Gas einzusparen, damit auch Antireflexschichten bzw. Reflexionsverluste, gemäß den Ansprüchen 13 und 14.

Die Wärmeleitfähigkeit und die Wärmeausdehnung beider Stoffe sind sehr ähnlich:

| Wärmeleitfähigkeit | Ausdehnung |
|---|---|
| LiF 4,01 W/m/K | 37,0 * 10$^{-6}$/C |
| NaF 3,75 W/m/K | 36,0 * 10$^{-6}$/C |

Damit kann ein "Kittglied" durch Ansprengen geschaffen werden, das je eine + und -Linse oder zwei + und eine -Linse enthält. Da die Brechzahlen beider Kristalle sehr niedrig sind und die Entspiegelung daher schwierig, ist diese Kittgliedbildung besonders hilfreich.

Neben einzelnen solcher Kittglieder könnte das Objektiv ansonsten aus CaF$_2$-Linsen bestehen.

Auch angesprengte Glieder aus CaF$_2$ und BaF$_2$ sind möglich:

| Wärmeleitfähigkeit | Ausdehnung |
|---|---|
| CaF$_2$ 19,71 W/m/K | 18,8 * 10$^{-6}$/C |
| BaF$_2$ 11,72 W/m/K | 18,1 * 10$^{-6}$/C |

Erst die ausgezeichneten Wärmeleitfähigkeiten der Kristalle gegenüber Gläsern läßt derartige Ansprengungen sicher erscheinen, insbesondere bei unterschiedlicher Absorption (und damit Erwärmung).

Als weitere Kristalle sind vor allem Mischkristalle des Fluor geeignet, darunter solche mit Alkali oder Erdalkali und anderen Elementen, wie Zinn, Zink oder Aluminium. Hohe Dispersion und gute Lichtbeständigkeit bei hoher Transmission im VUV sind dabei die Auswahlkriterien, bei Meidung von Doppelbrechung.

Natürlich gelten die obigen Aussagen auch für Linsen in einem katadioptrischen Objektiv, insbesondere auch für dabei verwendete refraktive Teilobjektive. Das erfindungsgemäße Objektiv kann also auch katadioptrisch sein. Wichtig ist, daß Linsen, und nicht nur optische Hilfselemente wie Umlenkprismen oder Planplatten aus Kristall bestehen.

Näher erläutert wird die Erfindung anhand der Zeichnung, deren

Figur 1 einen Linsenschnitt eines 157 nm Mikrolithographie-Projektionsobjektivs mit $BaF_2$-Linsen zeigt;

Figur 2 einen Linsenschnitt eines 157 nm Mikrolithographie-Projektionsobjektivs mit NaF-Linsen und Asphären zeigt;

Figur 3 ein qualitatives Bild einer Projektionsbelichtungsanlage der Mikrolithographie zeigt;

Figur 4 schematisch ein Projektionsobjektiv mit Kittglied zeigt; und

Figur 5 schematisch ein katadioptrisches Projektionsobjektiv zeigt.

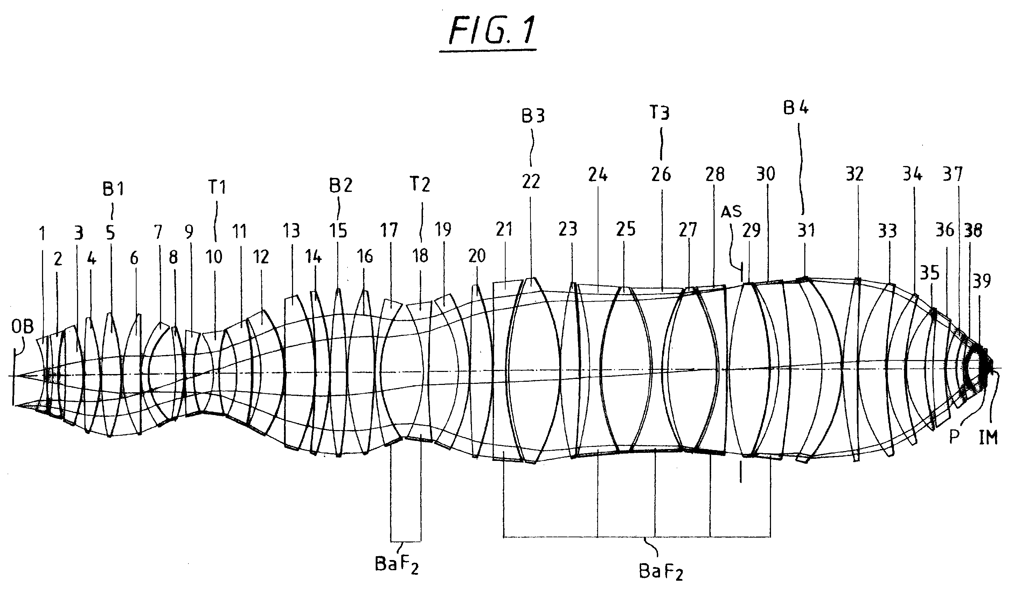

Zu dem in Figur 1 im Linsenschnitt gezeigten Ausführungsbeispiel gibt Tabelle 1 die Daten an.

Es handelt sich um ein Mikrolithographie-Projektionsobjektiv für den $F_2$-Excimer-Laser bei 157 nm. Durch den Einsatz von $CaF_2$ und $BaF_2$ (für die Linsen 17, 18, 21, 24, 26, 28, 30) gelang es, bei einer Bandbreite von 0,5 pm, einem Stitching-gerechten Bildfeld von 8,0 x 13,0 $mm^2$, einem Reduktionsfaktor von 4,0 : 1, einem Abstand Objekt Ob zu Bild Im von 1000 mm und bei beidseitiger Telezentrie eine numerische Apertur von 0,8 zu verwirklichen. Eine weitere Erhöhung der numerischen Apertur ist durchaus möglich. Der Farblängsfehler wird um Faktor 3 gegenüber einem reinen $CaF_2$ Objektiv reduziert. Er beträgt noch CHL (500 pm) = 0,095 mm. Dieser Faktor kann durch zusätzliche $CaF_2$ - $BaF_2$ Linsenpaare noch gesteigert werden. Der gesamte RMS-Fehler der Wellenfront im Bild IM liegt für alle Bildhöhen bei RMS < 13 m $\lambda$, wobei ja die deutlich reduzierte Wellenlänge als Bezugsmaß $\lambda$ dient.

Die Brechzahlen bei der Hauptwellenlänge $\lambda_0$ = 157,63 nm des $F_2$-Excimer-Lasers und in 500 pm Abstand bei $\lambda_1$ = 158,13 nm sind

$n_o$ = 1,5584 $n_1$ = 1,5571 für $CaF_2$
$n_o$ = 1,6506 $n_1$ = 1,6487 für $BaF_2$
$n_o$ = 1,5102 $n_1$ = 1,5097 für $SrF_2$
$n_o$ = 1,4781 $n_1$ = 1,4474 für LiF
$n_o$ = 1,4648 $n_1$ = 1,4629 für NaF
$n_o$ = 1,5357 $n_1$ = 1,5328 für KF

Daraus ergibt sich eine Abbe-Zahl (invers zur Dispersion):

| | | |
|---|---|---|
| $\upsilon CaF_2$ = 1219 | $\upsilon BaF_2$ = 874 | $\upsilon SrF_2$ = 392 |
| $\upsilon LiF$ = 674 | $\upsilon NaF$ = 242 | $\upsilon KF$ = 184. |

Damit hat bei 157 nm $BaF_2$ eine um 40% höhere Dispersion als $CaF_2$. Im Vergleich hat bei 193 nm Quarzglas eine um 54% Dispersion als $CaF_2$.

Das Projektionsobjektiv nach Figur 1 und Tabelle 1 hat insgesamt 39 Linsen und eine planparallele Abschlußplatte P. Sieben Negativlinsen 17, 18, 21, 24, 26, 28 und 30 sind zur Achromatisierung aus $BaF_2$ gemacht. Die Konstruktion steht in direkter Verwandtschaft zu dem in der obengenannten nicht vorveröffentlichten Patentanmeldung DE 19855157.6 (deren Inhalt auch Teil dieser Anmeldung sein soll) beschriebenen Design.

Im Bereich der Systembiende AS ist eine - nicht stark eingeschnürte - dritte Taille T3 bei der Linse 26 ausgebildet, folgend auf die schon klassische Folge von Bauch B1 an Linse 5, Taille T1 an Linse 10, Bauch B2 an Linse 15, Taille T2 an Linse 18 und Bauch B3 an Linse 22, sowie gefolgt von Bauch B4. Besonders hoch entwickelt ist die Linsengruppe von Linse 20 bis 39 mit dem Doppelbauch B3, B4.

Mehrere sphärisch überkorrigierende Lufträume mit größerer Dicke in der Mine als am Rand sind im Bereich der Blende AS zwischen den Linsen 23/24, 26/27 und 29/30, 30/31 als wesentliches Korrektionsmittel vorgesehen. Dieser Aufbau begrenzt auch bei größter numerischer Apertur die Linsendurchmesser. Die in Tabelle 1 angegebenen Linsenradien - entsprechend den jeweils größten Strahlhöhen - zeigen, daß der Linsendurchmesser maximal 190 mm am Bauch B4 beträgt. Auch sind die Linsendurchmesser ziemlich gleichmäßig verteilt, von Linse 13 im Bereich des zweiten Bauchs B2 bis Linse 34 nahe dem Bild IM liegen alle Linsendurchmesser zwischen 140 mm und 190 mm.

Die negativen $BaF_2$-Linsen 21, 24, 26, 28, 30 sind in klassischen + - Paaren mit positiven $CaF_2$-Linsen 22, 23, 25, 27, 29 abwechselnd im Bereich des Doppelbauchs B3, B4 vorwiegend vor der Blende AS angeordnet und werden durch zwei negative $BaF_2$-Linsen 17, 18 im Bereich der zweiten Taille T2 ergänzt. Damit ergibt sich ein sehr wirksamer Einsatz des zweiten Kristallmaterials zur Achromatisierung.

Der den Ansprüchen 9 oder 10 gemäße Einsatz zweier Kristall-Linsenwerkstoffe ergibt sich ausgehend von den beispielsweise aus den Patentanmeldungen DB 19855108.8 und DB 19855157.6 des Anmelders vom gleichen Anmeldetag und aus anderen Quellen bekannten Objektivdesigns dadurch, daß bei einem DUV-Objektiv (300-180 nm) mit überwiegend Quarzglas-Linsen und vorwiegend blendennahen, der Achromatisierung dienenden $CaF_2$-Linsen die dem Bild IM nächsten Linsen - entsprechend in Figur 1 Linsen 39, 38 usw. - aus Quarzglas oder $CaF_2$, jetzt durch $BaF_2$- oder $SrF_2$-Linsen ersetzt werden. Die nur wenig anderen optischen Eigenschaften des $BaF_2$ und des $SrF_2$ gegenüber Quarzglas erfordern nur routinemäßige Designänderungen mit einem Optik-Design-Programm. Natürlich kann auch die Planplatte P sinnvoll aus $BaF_2$ gemacht werden. Wird sie jedoch - als Verschleiß- und Schutzelement - ohnedies öfters gewechselt, kann sie auch aus Quarzglas bleiben (im oben genannten Wellenlängenbereich)

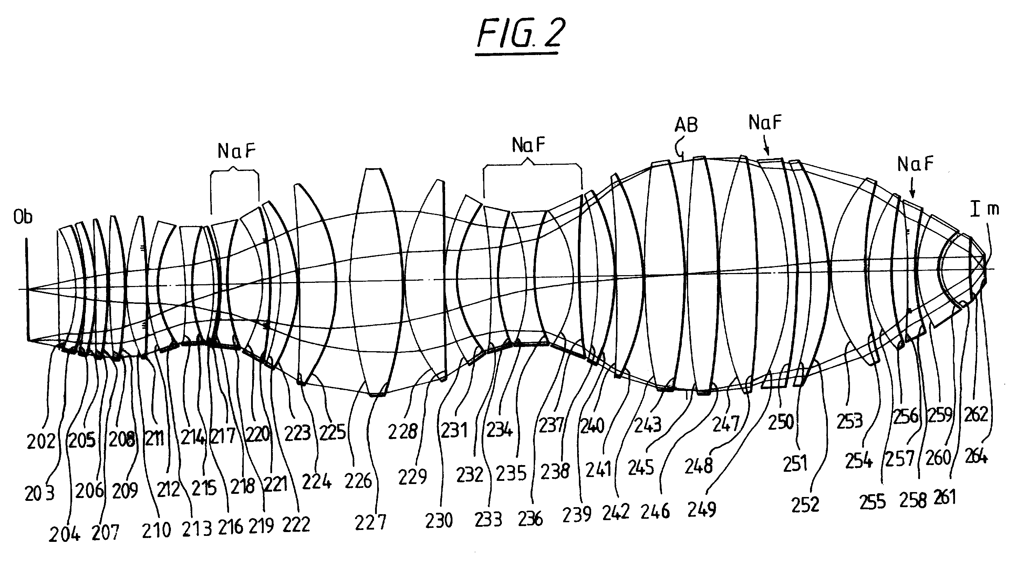

Das Ausführungsbeispiel der Figur 2 zeigt ein 157 nm-Vollfeld-Scanner-Projektionsobjektiv auf der Basis von $CaF_2$-Linsen, das durch den Einsatz von insgesamt fünf Negativlinsen 218, 219, 220, 221; 232, 233, 234, 235; 236, 237; 249, 250; 257, 258 aus NaF in den beiden Taillen, im Blendenraum und im konvergierenden Strahlengang vor der Bildebene Im achromatisiert ist.

Insgesamt drei asphärische Linsenflächen 211, 221, 257, davon zwei auf NaF, tragen zur guten Korrektur bei kompaktem, materialsparendem Bau des Objektivs bei.

Abbildungsmaßstab 1:4, Bildfelddurchmesser 27,2 mm für ein 8 x 26 mm Scanner-Vollfeld und bildseitige numerische Apertur von NA = 0,77 sind wesentliche Kenndaten des Objektivs, dessen RMS-Bildfehler über alle Bildhöhen unter 16 m$\lambda$ liegt, bei einer Laser-Bandbreite von $\Delta\lambda = \pm 0,2$ pm. Die chromatische Längsaberration für den Vergleichswert $\Delta\lambda = 500$ pm beträgt CHL (500 pm) = 0,153 mm. Die einzelnen Geometriedaten sind in Tabelle 2 zusammengestellt. Der größte genutzte Linsendurchmesser beträgt 46 mm an der Linse 247, 248.

Die Gestaltung und Nutzung der Asphären erfolgt hierbei nach den Grundsätzen der Patentanmeldung DE 199 22 209.6 vom 14. Mai 1999 des gleichen Erfinders und Anmelders, die hiermit als Teil der Offenbarung auch dieser Anmeldung gelten soll.

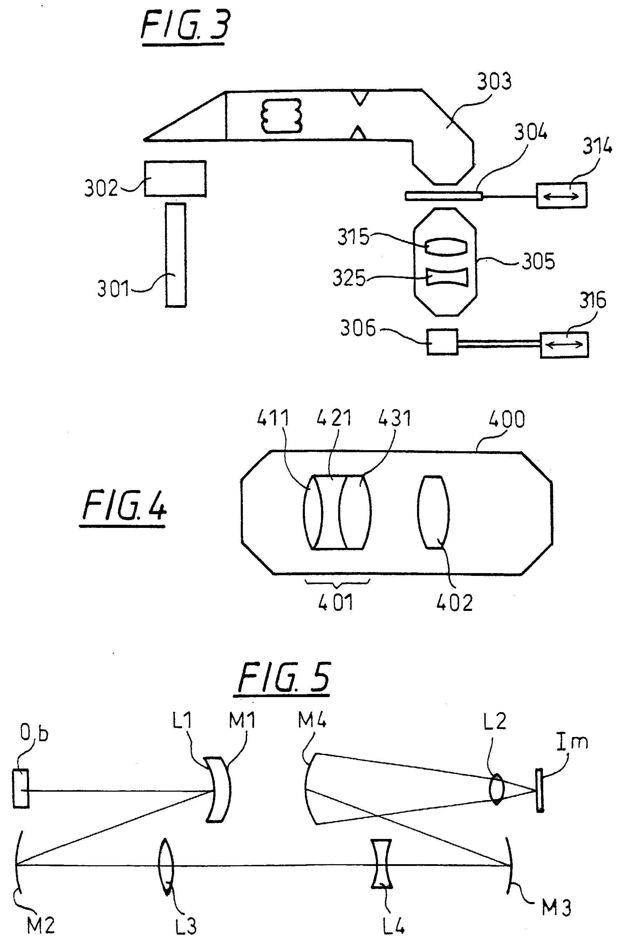

Die in Figur 3 schematisch dargestellte Projektionsbelichtungsanlage der Mikrolithographie umfaßt als Lichtquelle 301 einen Excimer-Laser, eine Einrichtung 302 zur Bandbreitenreduktion - die auch im Laser integriert sein kann -, ein Beleuchtungssystem 303 mit Homogenisierungs- und Feldblendeneinrichtung u.a., einen Maskenhalter 304 mit Positionier- und Bewegungseinrichtung 314. Ein erfindungsgemäßes Projektionsobjektiv 305 umfaßt Linsen 315, 325 aus verschiedenen Kristallen bzw. Fluoriden. In der Bildebene wird das Objekt auf einem Objekthalter 306 mit Positionier- und Bewegungseinrichtung 316 bereitgestellt. In der Ausführung als Scanner werden Masken- und Objekthalter synchron in um den Abbildungsmaßstab unterschiedlicher Geschwindigkeit bewegt. Natürlich gehören die hier nicht dargestellten Einrichtungen einer Projektionsbelichtungsanlage wie Steuer- und Regelsysteme, Autofokus, Wafer- und Maskenwechselsysteme, Klimatisierung auch dazu.

Figur 4 zeigt ein Objektiv 400 mit einem "Kittglied" 401, d.h. eine ohne Luftspalt gefügte Linsengruppe, die in diesem tiefen UV-Bereich durch Ansprengen gehalten wird, da kein strahlungsbeständiger Kitt/Kleber verfügbar ist. Wie oben gesagt, sind solche Glieder mit positiven LiF und negativen NaF Linsen sinnvoll bzw. mit $BaF_2$ und $CaF_2$. Weitere Linsen 402 im Objektiv 400 sind dann z.B. aus $CaF_2$ oder einem anderen der oben beschriebenen Materialien gefertigt.

Figur 5 zeigt schematisch ein erfindungsgemäßes katadioptrisches Objektiv, wie es für die Lithographie mit 126 nm oder 109 nm vorgeschlagen wird.

Das Objekt Ob wird mittels 4 Spiegeln M1 bis M4 und 4 Linsen L1 bis L4 auf die Bildebene Im abgebildet. Eine Linse L1 ist mit dem Spiegel M1 zu einem Mangin-Spiegel vereinigt. Dies erleichtert die Fertigung und reduziert Reflexionsverluste und -störungen. Die Linsen L1, L3, L4, in denen das Strahlungsbündel großen Querschnitt und damit geringe Intensität aufweist, sind aus LiF gefertigt. Die bildnahe Linse L2, die zur Steigerung der numerischen Apertur gebraucht wird, ist aber konzentrierter Strahlung ausgesetzt. Hierfür wird amorphes $BeF_2$ eingesetzt, wegen seiner höheren Strahlungsbeständigkeit.

Das katadioptrische Objektiv soll wegen der Absorption und der relativ schwierigen Herstellung der Linsenwerkstoffe nur wenige Linsen, d.h. 1 bis 10, enthalten. Derartige Mikrolithographie-Projektionsobjektive sind z.B. für 193 nm bekannt, vgl. US 4,701,035 Fig. 12 und US 5,815,310 Fig. 3 mit NA = 0,6 und Quarzglas als Linsenmaterial. Von solchen Systemen ausgehend können konkrete Ausführungen erfindungsgemäßer Objektive abgeleitet werden, unter Vorgabe der optischen Eigenschaften der neu vorgegebenen Materialien.

Auch für die anderen Objektivkonstruktionen der Erfindung ist grundsätzlich die Detailkonstruktion mittels Design-Programmen aus vorhandenen Designs abzuleiten. Dafür sind Brechzahl und Dispersion der Materialien bei den jeweiligen Betriebswellenlängen einzusetzen.

Aus "Handbook of Optics", McGraw-Hill 1995, Ch. 33 Properties of Crystals and Glasses, p. 33.64, ref. [125] sind beispielsweise die Dispersionskurven von

LiF ab 100 nm
NaF ab 150 nm, mit Extrapolation ab 130 nm
KF ab 150 nm, mit Extrapolation ab 130 nm

bekannt.

Zu den Absorptionskanten von $BaF_2$, $CaF_2$, $MgF_2$, $SrF_2$ und $LiF_2$ finden sich Informationen in GB 1 276 700 betreffend ein Bandpaßfilter bei 130 nm.

Optische Konstanten der angesprochenen Antireflexschichten finden sich beispielsweise in M. Zukic et al. Applied Optics $\underline{29}$ No. 28, Oct. 1980, p 4284-4292.

Die angegebenen Literaturstellen sind natürlich nur Beispiele. Außerdem können die genauen optischen Eigenschaften auch durch Vermessung von Proben mit einem UV-Spektrometer gewonnen werden.

In der Tabelle 3a sind die Abbezahlen υ einiger Fluoride und zum Vergleich von Quarzglas für die Wellenlängen des ArF- und des $F_2$-Excimerlasers angegeben.

Daraus abgeleitet sind die Quotienten der Abbezahlen in Tabelle 3b für verschiedene Kron/Flint Kombinationen bei 157 nm angegeben. Großer Quotient bedeutet starke Farbfehlerkorrektur mit wenig Flint.

Demnach wäre die Kombination Kron LiF, Flint KF ideal. Die schwierigen Eigenschaften von KF sprechen aber dagegen (Absorption, Wasserempfindlichkeit).

Jedoch kann mit dem Kron $CaF_2$ nur die Kombination mit NaF gegenüber den Kombinationen mit LiF als Kron konkurrieren.

Sobald die Herstellung von Linsen aus LiF der von $CaF_2$-Linsen vergleichbar gut möglich ist, sind also Objektivkonstruktionen mit LiF als Kron vorzuziehen, in Kombination etwa mit $BaF_2$ oder NaF.

Der erfindungsgemäße Einsatz von Kristall-Linsen bringt auch bei katadioptrischen Systemen im Wellenlängenbereich 100 bis 200 nm die gleichen Vorteile.

Eine Projektionsbelichtungsanlage mit erfindungsgemäßem Objektiv entspricht zum Beispiel den aus den genannten Patentanmeldungen und anderen Quellen bekannten Aufbauten, jetzt allerdings mit dem erfindungsgemäßen Objektiv.

Für 157 nm Systeme ist ein $F_2$-Excimer-Laser mit moderatem Aufwand zur Bandbreitenbegrenzung, ein angepaßtes Beleuchtungssystem z.B. nach der Patentanmeldung DE 19855106, jedenfalls mit Fluorid und/oder Spiegel-Optik, aber auch z.B. mit erfindungsgemäßem Objektiv, vorzusehen. Dazu kommen Masken- und Wafer-Positionier- und Handlingssysteme usw. zu dem erfindungsgemäßen Projektionsobjektiv.

Diese asphärischen Flächen werden durch die Gleichung:

$$P(h) = \frac{\delta * h^2}{1 + \sqrt{1 - (-EX) * \delta^2 * h^2}} + C_1 h^4 + ... + C_n h^{2n+2} \qquad \delta = 1/R$$

beschrieben, wobei P die Pfeilhöhe als Funktion des Radius h (Höhe zur optischen Achse 7) mit den in den Tabellen angegebenen asphärischen Konstanten $C_1$ bis $C_n$ ist. R ist der in den Tabellen angegebene Scheitelradius.

## Tabelle 1

| Element | Krümmungsradius | Dicke | Material | Linsenradius |
|---------|-----------------|-------|----------|--------------|
| Ob | ∞ | 8,646 | | 34,52 |
| 1 | -89,212 | 4,219 | CaF$_2$ | |
| | -16234,578 | 5,440 | | 38,01 |
| 2 | -264,742 | 5,333 | CaF$_2$ | |
| | 252,387 | 7,720 | | 43,32 |
| 3 | -660,451 | 17,777 | CaF$_2$ | |
| | -140,998 | ,752 | | 50,10 |
| 4 | 1064,631 | 16,556 | CaF$_2$ | |
| | -158,471 | ,750 | | 57,46 |
| 5 | 334,549 | 20,500 | CaF$_2$ | |
| | -185,783 | ,750 | | 61,97 |
| 6 | 123,299 | 18,438 | CaF$_2$ | 60,05 |
| | 6416,942 | ,250 | | |
| 7 | 80,830 | 6,933 | CaF$_2$ | 52,10 |
| | 59,684 | 29,393 | | |
| 8 | -270,673 | 7,923 | CaF$_2$ | 45,95 |
| | -138,947 | 1,854 | | |
| 9 | -4994,395 | 6,686 | CaF$_2$ | 42,27 |
| | 100,936 | 20,795 | | |
| 10 | -77,364 | 5,536 | CaF$_2$ | 38,79 |
| | 138,364 | 18,752 | | |
| 11 | -102,745 | 16,748 | CaF$_2$ | |
| | -267,729 | 7,811 | | 52,63 |
| 12 | -130,631 | 24,060 | CaF$_2$ | |
| | -118,058 | ,755 | | 63,21 |
| 13 | -17113,629 | 30,658 | CaF$_2$ | |
| | -185,673 | ,550 | | 77,37 |

| | | | | |
|---|---|---|---|---|
| 14 | -763,483 | 14,068 | CaF$_2$ | |
| | -257,169 | ,450 | | 81,41 |
| 15 | 538,062 | 17,501 | CaF$_2$ | |
| | -524,097 | ,450 | | 83,64 |
| 16 | 225,158 | 28,126 | CaF$_2$ | 82,00 |
| | -455,940 | ,450 | | |
| 17 | 288,200 | 5,280 | BaF$_2$ | 73,64 |
| | 116,070 | 43,999 | | |
| 18 | -136,780 | 5,899 | BaF$_2$ | |
| | 596,541 | 30,232 | | 70,04 |
| 19 | -126,579 | 12,715 | CaF$_2$ | |
| | -160,434 | ,450 | | 77,54 |
| 20 | 1476,691 | 23,253 | CaF$_2$ | |
| | -252,721 | ,450 | | 86,85 |
| 21 | -2817,234 | 11,778 | BaF$_2$ | |
| | 231,190 | 1,794 | | 90,96 |
| 22 | 231,573 | 53,989 | CaF$_2$ | |
| | -192,300 | ,453 | | 93,26 |
| 23 | 362,633 | 20,787 | CaF$_2$ | 88,11 |
| | -787,951 | 9,876 | | |
| 24 | -299,764 | 10,937 | BaF$_2$ | 86,45 |
| | 190,174 | ,750 | | |
| 25 | 183,395 | 50,343 | CaF$_2$ | 83,31 |
| | -174,748 | 2,226 | | |
| 26 | -164,440 | 10,352 | BaF$_2$ | 82,14 |
| | 168,479 | 5,874 | | 81,42 |
| 27 | 206,740 | 50,425 | CaF$_2$ | |
| | -153,785 | 1,751 | | 82,83 |
| 28 | -154,941 | 8,763 | BaF$_2$ | |
| | -1457,609 | ,700 | | 84,91 |
| 29 | 254,394 | 43,058 | CaF$_2$ | 87,38 |

| AS | Blende | ,000 | | 87,38 |
|---|---|---|---|---|
| | -217,033 | 9,211 | | |
| 30 | -162,604 | 12,000 | BaF$_2$ | |
| | -511,982 | 32,352 | | 89,88 |
| 31 | -179,731 | 19,652 | CaF$_2$ | |
| | -150,853 | 1,959 | | 83,87 |
| 32 | 357,035 | 16,035 | CaF$_2$ | 92,29 |
| | 2402,661 | ,935 | | |
| 33 | 141,252 | 27,158 | CaF$_2$ | 86,94 |
| | 445,801 | ,751 | | |
| 34 | 121,230 | 20,012 | CaF$_2$ | 75,94 |
| | 251,005 | ,750 | | |
| 35 | 89,189 | 18,534 | CaF$_2$ | 62,04 |
| | 183,720 | 7,397 | | |
| 36 | 490,596 | 13,526 | CaF$_2$ | 58,00 |
| | 255,332 | ,750 | | 48,00 |
| 37 | 77,348 | 8,959 | CaF$_2$ | 39,69 |
| | 53,255 | 7,818 | | |
| 38 | 115,034 | 2,770 | CaF$_2$ | 30,44 |
| | 27,832 | 1,250 | | |
| 39 | 27,548 | 14,863 | CaF$_2$ | 22,66 |
| | 193,984 | 2,347 | | |
| P | ∞ | 1,211 | CaF$_2$ | 18,16 |
| IM | ∞ | | | 17,43 |

| Element | Krümmungsradius | Dicke | Material |
|---|---|---|---|
| 06 | | 17.3892 | |
| 2 | -134.1462 | 9.9551 | CAF2 |
| 3 | -195.6788 | .7000 | |
| 4 | -256.1348 | 10.3165 | CAF2 |
| 5 | -215.7111 | .7000 | |
| 6 | -1188.4145 | 12.7743 | CAF2 |
| 7 | -266.9759 | .7000 | |
| 8 | 768.1676 | 17.0432 | CAF2 |
| 9 | -326.8752 | .7000 | |
| 10 | 201.9820 | 20.6243 | CAF2 |
| 11 | -1127.2372 A | .7000 | |
| 12 | 194.8406 | 10.7431 | CAF2 |
| 13 | 103.5380 | 29.2205 | |
| 14 | -439.7364 | 7.0000 | CAF2 |
| 15 | 157.9775 | 22.6930 | |
| 16 | -211.6271 | 7.1822 | CAF2 |
| 17 | -176.9514 | .7259 | |
| 18 | -205.5616 | 7.0000 | NAF |
| 19 | 207.9612 | 36.0232 | |
| 20 | -119.6353 | 7.2489 | NAF |
| 21 | -413.0417 A | 10.3726 | |
| 22 | -218.9613 | 19.5719 | CAF2 |
| 23 | -153.1211 | .7433 | |
| 24 | -1678.0689 | 38.5556 | CAF2 |
| 25 | -171.3517 | 14.2594 | |
| 26 | 390.6431 | 55.0613 | CAF2 |
| 27 | -340.4367 | 1.0036 | |
| 28 | 170.6572 | 41.3431 | CAF2 |
| 29 | 2149.7419 | .7000 | |
| 30 | 179.2959 | 13.8028 | CAF2 |
| 31 | 122.0160 | 35.7868 | |
| 32 | -451.7398 | 7.0000 | NAF |
| 33 | 181.5824 | 30.6167 | |
| 34 | -161.3435 | 7.0000 | NAF |
| 35 | 163.5622 | 41.2995 | |
| 36 | -111.4273 | 7.1203 | NAF |
| 37 | 736.5475 | 19.4954 | |
| 38 | -304.5919 | 18.3054 | CAF2 |
| 39 | -195.3438 | .7785 | |
| 40 | -1945.5147 | 29.2366 | CAF2 |
| 41 | -231.5183 | .8597 | |
| 42 | 622.3005 | 42.0816 | CAF2 |
| 43 | -517.5539 | .0001 | |
| AB | | 2.8420 | |
| 45 | 856.7969 | 32.8647 | CAF2 |
| 46 | -609.0558 | .8543 | |
| 47 | 328.0241 | 39.3550 | CAF2 |
| 48 | -810.7543 | 33.1869 | |
| 49 | -246.7339 | 9.3143 | NAF |
| 50 | -513.0495 | 15.0989 | |
| 51 | -342.1676 | 18.9964 | CAF2 |
| 52 | -240.4190 | .9015 | |
| 53 | 142.3229 | 36.3765 | CAF2 |
| 54 | 358.3715 | 2.9965 | |
| 55 | 131.5538 | 23.5624 | CAF2 |
| 56 | 257.3044 | 15.9366 | |
| 57 | -1240.0410 A | 10.0142 | NAF |
| 58 | 269.2267 | .7289 | |
| 59 | 113.1907 | 23.1921 | CAF2 |
| 60 | 47.2686 | 2.3140 | |
| 61 | 46.5346 | 30.1367 | CAF2 |
| 62 | 354.0845 | 15.8942 | |
| [M | | | |

Tabelle 2

ASPHAERISCHE KONSTANTEN

21 A
$C_1$ .15637086E+03
$C_3$ .22009617E-11
$C_5$ .27054723E-19
$C_4$ .14048141E-07
$C_6$ .37664501E-23

21 A
$C_4$ .47644602E-27
$C_3$ .29916689E-16
$C_5$ .18134368E-19
$C_7$ .95744229E+00
$C_2$ .13628853E-07
$C_5$ .13590312E-16

57 A
$C_2$ .24243733E-23
$C_4$ .23291310E-27
$C_5$ .16469029E-20
$C_1$ .00000000E+00
$C_7$ .80987234E-13
$C_4$ .22189367E-16
$C_2$ .46722013E-08

Tabelle 3a

| Abbezahlen | | |
|---|---|---|
| Wellenlänge | 193,63 nm | 157,63 nm |
| LiF | 1344,27 | 674,56 |
| $CaF_2$ | 1024,36 | 436,94 |
| $SrF_2$ | 954,39 | 391,89 |
| $BaF_2$ | 807,43 | 344,42 |
| $SiO_2$ | 714,96 | 274,61 |
| NaF | 705,92 | 242,51 |
| KF | 648,04 | 184,19 |

Definition

$$\upsilon_{193} = \frac{n\ 193,304 - 1}{n193,304 - n\ 193,804}$$

$$\upsilon_{157} = \frac{n\ 157,63 - 1}{n157,63 - 158,13}$$

Tabelle 3b

| Dispersionsvergleich 157 nm | | |
|---|---|---|
| Flint | Kron LiF | Kron $CaF_2$ |
| $CaF_2$ | 1,549 | - |
| $SrF_2$ | 1,721 | 1,115 |
| $BaF_2$ | 1,959 | 1,269 |
| NaF | 2,782 | 1,802 |
| KF | 3,662 | 2,372 |

**Patentansprüche**

1. Objektiv mit Linsen aus mindestens zwei verschiedenen Kristallen.

2. Objektiv nach Anspruch 1, dadurch gekennzeichnet, daß die Linsen aus mindestens zwei verschiedenen Fluori-den, insbesondere aus $CaF_2$, $BaF_2$, $SrF_2$, LiF, NaF, KF bestehen.

3. Objektiv nach Anspruch 1 oder 2 mit zusätzlichen Linsen aus glasartigem Material, insbesondere Quarzglas oder amorphem $BeF_2$.

4. Projektionsobjektiv der Mikrolithographie, korrigiert für die Beleuchtung mit einem $F_2$-Excimer-Laser bei 157 nm, dadurch gekennzeichnet, daß es rein refraktiv ist und Linsen aus $BaF_2$, $SrF_2$, NaF, LiF oder KF enthält.

5. Projektionsobjektiv nach Anspruch 4, dadurch gekennzeichnet, daß als weiteres Kristall-Linsenmaterial $CaF_2$ ein-gesetzt ist.

**6.** Projektionsobjektiv nach Anspruch 4 oder 5, dadurch gekennzeichnet, daß einzelne Negativlinsen aus $BaF_2$ oder $SrF_2$ oder NaF gefertigt sind.

**7.** Projektionsobjektiv nach Anspruch 5 oder 6, dadurch gekennzeichnet, daß alle Positivlinsen und einzelne Negativlinsen aus $CaF_2$ gefertigt sind.

**8.** Projektionsobjektiv nach mindestens einem der Ansprüche 4 bis 7, dadurch gekennzeichnet, daß die bildseitige numerische Apertur über 0,5, vorzugsweise über 0,6, beträgt.

**9.** Refraktives Projektionsobjektiv der Mikrolithographie, korrigiert für die Beleuchtung mit Wellenlängen unter 360 nm, enthaltend Linsen aus Quarzglas, dadurch gekennzeichnet, daß mindestens eine der beiden der Bildebene des Objektivs nächsten Linsen aus Kristall, vorzugsweise $CaF_2$, $SrF_2$ oder $BaF_2$, ausgeführt ist.

**10.** Objektiv nach Anspruch 3 oder 9, dadurch gekennzeichnet, daß es ein mikrolithographisches Projektionsobjektiv, korrigiert für die Laser-Beleuchtung mit einer Wellenlänge unter 360 nm, ist und die meisten Linsen aus Quarzglas, mehrere positive Linsen vorzugsweise in Blendennähe, zur Achromatisierung aus $CaF_2$ und eine oder mehrere objektseitige Linsen zum Verhindern des Compaction-Einflusses aus $BaF_2$ oder einem anderen Fluorid, insbesondere $SrF_2$, gefertigt sind.

**11.** Projektionsobjektiv der Mikrolithographie mit einer Arbeitswellenlänge von 100 - 180 nm mit Linsen aus mindestens zwei der Kristall-Materialien $CaF_2$, $BaF_2$, LiF, NaF, SrF, KF oder des amorphen $BeF_2$.

**12.** Projektionsobjektiv der Mikrolithographie, ausgeführt als katadioptrisches Objektiv mit einer Arbeitswellenlänge von 100 - 130 nm enthaltend Linsen aus LiF und/oder amorphem $BeF_2$.

**13.** Achromat-Linsengruppe bestehend aus aneinander angesprengten Linsen aus verschiedenen Fluoriden, insbesondere NaF und LiF oder $CaF_2$ und $BaF_2$.

**14.** Projektionsobjektiv mit mindestens einer Achromat-Linsengruppe nach Anspruch 13.

**15.** Objektiv nach mindestens einem der Ansprüche 1 bis 14, dadurch gekennzeichnet, daß mindestens eine Linse eine asphärische Fläche aufweist.

**16.** Objektiv nach mindestens einem der Ansprüche 1 bis 15, dadurch gekennzeichnet, daß Linsen eine Dünnschicht-Entspiegelung aus $MgF_2$ und/oder $LaF_3$ tragen.

**17.** Projektionsbelichtungsanlage mit 157 nm Lichtquelle und refraktivem Projektionsobjektiv.

**18.** Projektionsbelichtungsanlage der Mikrolithographie

- mit einer Lichtquelle, enthaltend einen Excimer-Laser mit 100 - 160 nm, vorzugsweise 100 - 150 nm Wellenlänge,
- mit einem Beleuchtungssystem, enthaltend refraktive optische Elemente aus einem oder mehreren Fluoriden, insbesondere Alkali- oder Erdalkalifluoriden,
- einem Retikel-Positionier- und Bewegungssystem
- mit einem Projektionsobjektiv mit Linsen aus mindestens zwei der Kristall-Materialien $CaF_2$, $BaF_2$, LiF, NaF, SrF, KF oder des amorphen $BeF_2$.
- mit einem Objekt-Positionier- und Bewegungssystem

**19.** Projektionsbelichtungsanlage, insbesondere nach Anspruch 17 oder 18, dadurch gekennzeichnet, daß das Projektionsobjektiv nach mindestens einem der Ansprüche 1 bis 15 ausgeführt ist.

**20.** Projektionsbelichtungsanlage nach mindestens einem der Ansprüche 17 bis 19, dadurch gekennzeichnet, daß sie für das Stitching-Verfahren ausgelegt ist.

**21.** Projektionsbelichtungsanlage nach mindestens einem der Ansprüche 18 bis 20, dadurch gekennzeichnet, daß ein Excimer-Laser mit 109, 126, 134, 146 oder 157 nm Wellenlänge als Lichtquelle eingesetzt ist.

**22.** Verfahren zur Herstellung mikrostrukturierter Bauteile, bei dem ein mit einer lichtempfindlichen Schicht versehenes Substrat mittels einer Maske und einer Projektionsbelichtungsanlage nach mindestens einem der Ansprüche 17 bis 21 durch ultraviolettes Laserlicht belichtet wird und einer Abbildung eines auf der Maske enthaltenen Musters strukturiert wird.

**23.** Objektiv nach Anspruch 1, dadurch gekennzeichnet, daß in mindestens einer Zerstreuungslinse ein Material eingesetzt ist, dessen Brechungsindex niedriger ist als der durchschnittliche Brechungsindex der in den Sammellinsen verwendeten Materialien.

*FIG.1*

EP 1 006 373 A2

## FIG.2

NaF NaF AB NaF NaF

Ob

Im

EP 1 006 373 A2

202 205 208 211 214 217 220 223 225 228 231 234 237 240 243 247 250 253 256 259 262

203 206 209 212 215 218 221 224 226 229 232 235 238 241 245 248 251 254 257 260 264

204 207 210 213 216 219 222 227 230 233 236 239 242 246 249 252 255 258 261

## _FIG. 3_

## _FIG. 4_

## _FIG. 5_